# EUROPEAN PATENT APPLICATION

(11) **EP 2 709 431 A1**
(43) Date of publication of application: **19.03.2014**
(21) Application number: 11865441.7
(22) Date of filing: 12.05.2011
(51) Int. Cl.: H05K 7/20, H01L 23/473

(54) **COOLER AND MANUFACTURING METHOD FOR COOLER**

(71) Applicant: TOYOTA JIDOSHA KABUSHIKI KAISHA, Toyota-shi, Aichi-ken, 471-8571 (JP)
(72) Inventor: KUSAKA, Hiroto, Aichi-ken, 471-8571 (JP)
(74) Representative: Kuhnen & Wacker
(86) International application number: PCT/JP2011/060932
(87) International publication number: WO 2012/153414

(57) **Abstract**

A cooler includes: a housing (20) in a form of a frame including a first opening and a second opening opposite to each other; a first radiator (21) including a first substrate (30) joined to the housing (20) to close the first opening, and a first heat radiation unit (31) provided on the first substrate (30); and a second radiator (22) including a second substrate (40) joined to the housing (20) to close the second opening, and a second heat radiation unit (41) provided on the second substrate (40), the first heat radiation unit (31) having a plurality of first fins (32), the second heat radiation unit (41) having a plurality of second fins (42), the first fins (32) each abutting against a tip of at least one second fin (42).

## Description

### TECHNICAL FIELD

The present invention relates a cooler and a method for producing the same.

### BACKGROUND ART

Conventionally, various cooling jackets, a heat exchanger such as described in Japanese Patent Laying-Open No. 2010-025521, and the like have been proposed as devices to cool devices and other objects to be cooled. For example, Japanese Patent Laying-Open No. 2010-141113 describes a cooling jacket including a jacket body having front and back surfaces with an opening and a seal provided at the front and back surfaces to seal the opening.

The jacket body internally has a hollow portion, and the opening is provided at the opposite end portions of the hollow portion.

The opening has a peripheral portion with a stepped bottom surface lowered by one step depthwise as seen from a surface of the jacket body. This stepped bottom surface functions as a supporting surface, and the supporting surface and the surface of the jacket body have a difference in level equal in dimension to the seal's thickness.

The seal includes a lid plate in the form of a plate and a plurality of fins provided on one surface of the lid plate, and the lid plate has a peripheral portion formed to be identical in geometry to a stepped side surface.

To produce the jacket, the lid plate is put on a step of the jacket body. The lid plate and the jacket are then joined together by friction stirring.

### CITATION LIST

### PATENT DOCUMENTS

PTD 1: Japanese Patent Laying-Open No. 2010-025521
PTD 2: Japanese Patent Laying-Open No. 2010-141113

### SUMMARY OF INVENTION

### TECHNICAL PROBLEM

Japanese Patent Laying-Open No. 2010-141113 describes a cooling jacket including a jacket body having a stepped bottom surface to support a lid plate, and accordingly, increased in thickness for the stepped bottom surface. As a result, the cooling jacket is increased in size.

The present invention has been made in view of the above issue, and contemplates a compact cooler and a method for producing the same.

### SOLUTION TO PROBLEM

The present invention provides a cooler including: a housing in a form of a frame including a first opening and a second opening opposite to each other; a first radiator including a first substrate joined to the housing to close the first opening, and a first heat radiation unit provided on the first substrate; and a second radiator including a second substrate joined to the housing to close the second opening, and a second heat radiation unit provided on the second substrate. The first heat radiation unit has a plurality of first fins, and the second heat radiation unit has a plurality of second fins. The first fins each abut against a tip of at least one of the second fins.

Preferably, the housing has an internal surface having a cross section, as seen in a direction perpendicular to that in which the first opening and the second opening are aligned, unvarying in geometry between the first opening and the second opening. The first substrate has a peripheral portion joined to the housing at the internal surface. The second substrate has a peripheral portion joined to the housing at the internal surface. Preferably, the housing is extrusion-molded. Preferably, the first radiator and the second radiator are extrusion-molded.

Preferably, the first fins extend in a first direction and are spaced in a second direction traversing the first direction. The second fins extend in the first direction and are spaced in the second direction. The first heat radiation unit has a contactless fin positioned between the first fins and out of contact with the second fins.

Preferably, the first fins extend in a first direction and are spaced in a second direction traversing the first direction. The second fins extend in the first direction and are spaced in the second direction. The first substrate has a peripheral portion including a first side portion and a second side portion aligned in the first direction. The first fin includes a first end portion located closer to the first side portion, and a second end portion located closer to the second side portion. The housing includes a first wall portion joined to the first side portion and having a supply port receiving a coolant, and a second wall portion joined to the second side portion and having a discharge port to discharge the coolant. The first end portion is reduced in height as the first end portion approaches the first side portion. The second end portion is reduced in height as the second end portion approaches the second side portion.

Preferably, the second substrate has a peripheral portion including a third side portion and a fourth side portion aligned in the first direction. The second fin includes a third end portion located closer to the third side portion, and a fourth end portion located closer to the fourth side portion. The third end portion is reduced in height as the third end portion approaches the third side portion. The fourth end portion is reduced in height as the fourth end portion approaches the fourth side portion.

Preferably, the first fins extend in a first direction and are spaced in a second direction traversing the first direction. The second fins extend in the second direction and are spaced in the first direction.

Preferably, the housing includes a third wall portion and a fourth wall portion aligned in the second direction. The first wall portion has a supply port receiving a coolant, and a discharge port to discharge the coolant. The first heat radiation unit includes a diaphragm to divide an interior of the housing into a first coolant chamber and a second coolant chamber. The supply port communicates with the first coolant chamber and the discharge port communicates with the second coolant chamber. Preferably, the first fins are larger in height than the second fins.

The present invention provides a method for producing a cooler, including the steps of: preparing a housing in a form of a frame including a first opening and a second opening opposite to each other; preparing a first radiator including a first substrate and a plurality of first fins formed on the first substrate; joining a peripheral portion of the first substrate to an internal surface of the first opening; preparing a second radiator including a second substrate and a plurality of second fins formed on the second substrate; and joining a peripheral portion of the second substrate to an internal surface of the housing, with the second fin and the first fin abutting against each other. Preferably, the method further includes the step of forming the housing by extrusion molding.

Preferably, the method further includes the steps of: forming the first radiator by extrusion molding; and forming the second radiator by extrusion molding.

### ADVANTAGEOUS EFFECT OF INVENTION

The present invention can provide a compact cooler. The present invention can provide a method for producing the compact cooler.

### BRIEF DESCRIPTION OF DRAWINGS

Fig. 1 is a block diagram of a hybrid vehicle with a cooling device and a cooling unit mounted therein according to a first embodiment.
Fig. 2 is a schematic perspective view of a cooling circuit that cools inverters 5 and 6.
Fig. 3 is a cross section of a cooler 14.
Fig. 4 is an exploded perspective view of cooler 14.
Fig. 5 is a cross section of cooler 14.
Fig. 6 is a perspective view showing a first step of a process for producing cooler 14.
Fig. 7 is a perspective view showing a step after the Fig 6 step.
Fig. 8 is a plan view showing the step of joining a housing 20 and a substrate 30 together.
Fig. 9 is a cross section of substrate 30 and a radiator 21 joined together.
Fig. 10 is a perspective view showing a step after an intermediate product 60 is produced.
Fig. 11 is a cross section showing intermediate product 60 with radiator 22 inserted therein.
Fig. 12 is a cross section of cooler 14 according to a second embodiment.
Fig. 13 is a cross section of cooler 14 according to a third embodiment.
Fig. 14 is an exploded perspective view of cooler 14 according to a fourth embodiment.
Fig. 15 is a side cross section of cooler 14.
Fig. 16 is an exploded perspective view of cooler 14 according to a fifth embodiment.
Fig. 17 is a cross section taken along a line XVII-XVII shown in Fig. 16.
Fig. 18 is a cross section taken along a line XVIII-XVIII.

### DESCRIPTION OF EMBODIMENTS

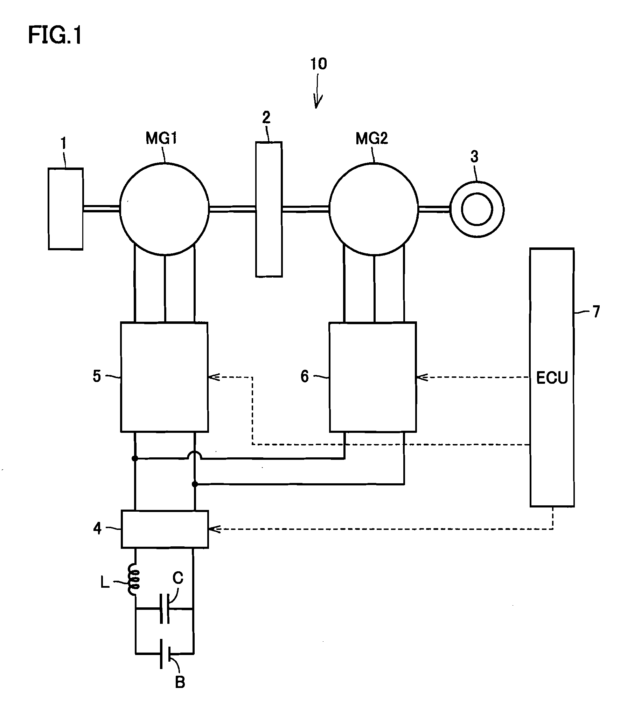

Fig. 1 to Fig. 18 are used to describe a cooler and a method for producing the same according to an embodiment of the present invention. Note that while the below embodiment will be described for an example of applying the present invention to a hybrid vehicle having an engine mounted therein as an internal combustion engine, the present invention is also applicable to an electric vehicle, a fuel cell vehicle and the like dispensing with an engine. In other words, the present invention is applicable to hybrid vehicles, fuel cell vehicles, electric vehicles and similar electrical powered vehicles.

### First Embodiment

Fig. 1 is a block diagram of a hybrid vehicle with a cooler mounted therein according to a first embodiment. In Fig. 1, a vehicle 10 includes an engine 1, motor generators MG1 and MG2, a power split device 2, a battery B, a capacitor C, a reactor L, a converter 4, inverters 5 and 6, and a vehicular electronic control unit (vehicular ECU) 7.

Power split device 2 is coupled with engine 1 and motor generators MG1 and MG2, and distributes motive power therebetween. For example, power split device 2 is implemented as a planetary gear mechanism having three shafts of rotation or a sun gear, a planetary carrier, and a ring gear. These three shafts of rotation are connected to those of engine 1 and motor generators MG1 and MG2. For example, motor generator MG1 has a hollowed rotor and at a center thereof engine 1 has a crankshaft passed therethrough to mechanically connect engine 1 and motor generators MG1 and MG2 to power split device 2.

Note that motor generator MG2 has its shaft of rotation coupled with a driving wheel or a front wheel 3 by a reduction gear, a differential gear or the like (not shown). Power split device 2 may have a speed reducer further incorporated therein for the shaft of rotation of motor generator MG2.

Motor generator MG1 is incorporated in vehicle 10 to operate as an electric power generator driven by engine 1 and also operate as an electric motor that can start engine 1. Motor generator MG2 is incorporated in vehicle 10 as an electric motor to drive the driving wheel of vehicle 10, or front wheel 3.

Motor generators MG1 and MG2 are three phase alternating current synchronous motors, for example. Motor generator MG1, MG2 includes as a stator coil a three phase coil formed of a U phase coil, a V phase coil, and a W phase coil.

Motor generator MG1 uses the engine's output to generate three phase alternating current voltage and outputs the generated three phase alternating current voltage to inverter 5. Motor generator MG1 receives three phase alternating current voltage from inverter 6 and uses it to generate driving force to start engine 1.

Motor generator MG2 receives three phase alternating current voltage from inverter 6 and uses it to generate torque to drive the vehicle. Motor generator MG2, in regeneratively braking the vehicle, generates and outputs three phase alternating current voltage to inverter 6. Note that inverters 5 and 6 are each formed of a plurality of devices, and for example include a plurality of insulated gate bipolar transistors (IGBTs) and a plurality of diodes.

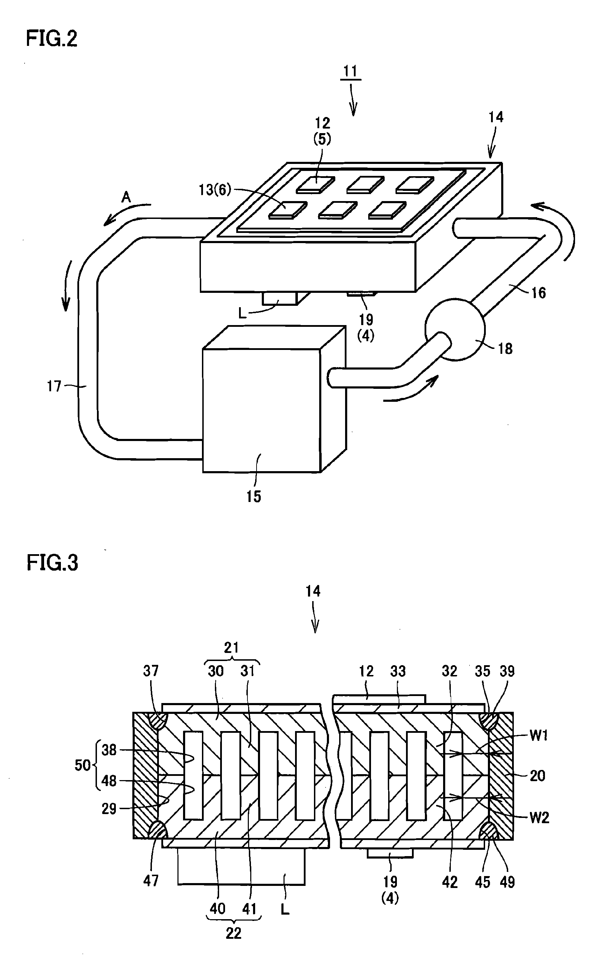

Fig. 2 is a schematic perspective view of a cooling circuit that cools inverters 5 and 6. Cooling circuit 11 includes: a cooler 14 that cools devices 12, 13, 19 and reactor L; a heat exchanger 15 that cools a coolant A passing through cooler 14; a supply pipe 16 and a discharge pipe 17 that connect heat exchanger 15 and cooler 14; and a pump 18. Note that devices 12 and 13 are the IGBT(s) or diodes of inverters 5 and 6, and device 19 is an IGBT or diode of converter 4.

Heat exchanger 15 is provided at a radiator for example and uses external air to cool coolant A.

Coolant A that has been cooled is supplied to cooler 14 by pump 18. Cooler 14 cools devices 12 and 13. Discharge pipe 17 supplies heat exchanger 15 with coolant A discharged from cooler 14.

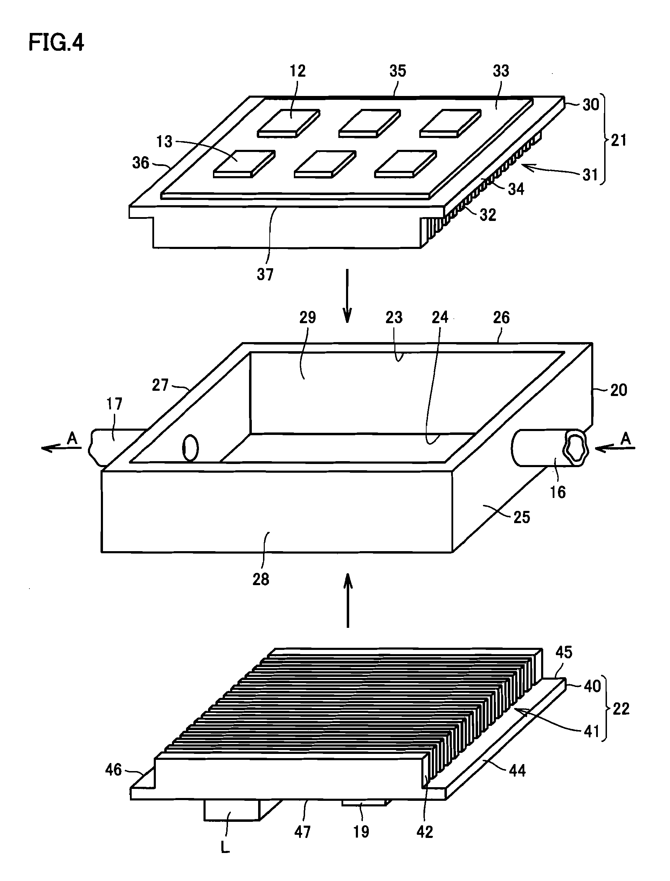

Fig. 3 is a cross section of cooler 14, and Fig. 4 is an exploded perspective view of cooler 14. In Fig. 3 and Fig. 4, cooler 14 includes a housing 20 formed in a frame, and radiators 21 and 22 housed in housing 20.

Housing 20 has a peripheral wall portion including a plurality of wall portions 25, 26, 27, 28, and housing 20 has opposite openings 23 and 24.

Wall portions 25 and 27 are mutually aligned in a first direction, and wall portions 26 and 28 are mutually aligned in a second direction. Wall portion 25 has supply pipe 16 connected thereto, and wall portion 27 has discharge pipe 17 connected thereto. Wall portions 25, 26, 27, 28 define an internal surface 29 of housing 20.

Internal surface 29 as seen in a direction perpendicular to that in which opening 23 and opening 24 are aligned has a cross section unvarying in geometry between opening 23 and opening 24. Note that unvarying/being identical in geometry as referred to herein also includes substantially unvarying/being substantially identical in geometry. Accordingly, it also includes a case with internal surface 29 unavoidably deformed in joining supply pipe 16, discharge pipe 17 and/or the like for example.

Radiator 21 includes a substrate 30 joined to housing 20 to close opening 23, and a heat radiation unit 31 provided on substrate 30.

Substrate 30 includes two main surfaces aligned depthwise. One main surface is provided with heat radiation unit 31, and the other main surface is provided with a heat sink 33. Devices 12 and 13 are disposed on heat sink 33.

Substrate 30 has a peripheral portion having side portions 34, 35, 36, 37. Side portions 34 and 36 are aligned in the first direction, and side portions 35 and 37 are aligned in the second direction.

In Fig. 3, substrate 30 has the peripheral portion joined to housing 20 at internal surface 29. Note that in the present embodiment, friction stir welding is employed to join substrate 30 and housing 20 together, and a joining portion 39 is provided between the peripheral portion of substrate 30 and internal surface 29.

Housing 20 has internal surface 29 without a step or the like to support substrate 30. Cooler 14 according to the present embodiment will now be compared with a cooler with a housing having a step. The housing having an internal surface with a step has a peripheral wall portion having a thickness (i.e., a thickness in a direction perpendicular to that in which opening 23 and opening 24 are aligned) increased by the width of the step. In contrast, cooler 14 according to the present embodiment allows housing 20 to be smaller in thickness and can thus be compact.

Heat radiation unit 31 has a plurality of radiating fins 32. Radiating fins 32 extend in the first direction and are spaced in the second direction. As shown in Fig. 3, grooves 38 are each formed between heat radiation units 31. Radiating fins 32 are disposed across heat radiation unit 31 from side portion 35 to side portion 37. Radiating fins 32 located at side portions 35 and 37 have a width W1 larger than that of other radiating fins 32. Note that the width of a radiating fin is a width thereof in a direction perpendicular to that in which the radiating fin extends.

In Fig. 4, radiating fin 32 has an end portion closer to side portion 34, receding from side portion 34 toward side portion 36, and radiating fin 32 has an end portion closer to side portion 36, receding from side portion 36 toward side portion 34.

Radiator 22 includes a substrate 40 to close opening 24, and a heat radiation unit 41 provided on substrate 40. Note that radiators 22 and 21 are substantially identical in geometry.

Substrate 40 is formed in a plate and includes two main surfaces aligned depthwise. Substrate 40 has one main surface provided with a heat radiation unit 41, and the other main surface provided with device 19 forming converter 4, reactor L and the like. Thus, cooler 14 is capable of cooling two surfaces.

Substrate 40 has a peripheral portion having side portions 44, 45, 46, 47. Side portions 44 and 46 are aligned in the first direction, and side portions 45 and 47 are aligned in the second direction.

In Fig. 3, substrate 40 has the peripheral portion joined to housing 20 at internal surface 29. A joining portion 49 is provided between the peripheral portion of substrate 40 and internal surface 29.

Heat radiation unit 41 has a plurality of radiating fins 42. Radiating fins 42 extend in the first direction and are spaced in the second direction. Grooves 48 are each formed between radiating fins 42. Radiating fins 42 and 32 abut against each other at their respective tips. Accordingly, grooves 38 and 48 define a coolant path 50 to pass coolant A therethrough.

Radiating fins 42 are disposed across heat radiation unit 41 from side portion 45 to side portion 47 and radiating fins 42 located at side portions 45 and 47 have a width W2 larger than that of other radiating fins 42.

In Fig. 4, radiating fin 42 has an end portion closer to side portion 44, receding from side portion 44 toward side portion 46, and radiating fin 42 has an end portion closer to side portion 46, receding from side portion 46 toward side portion 44.

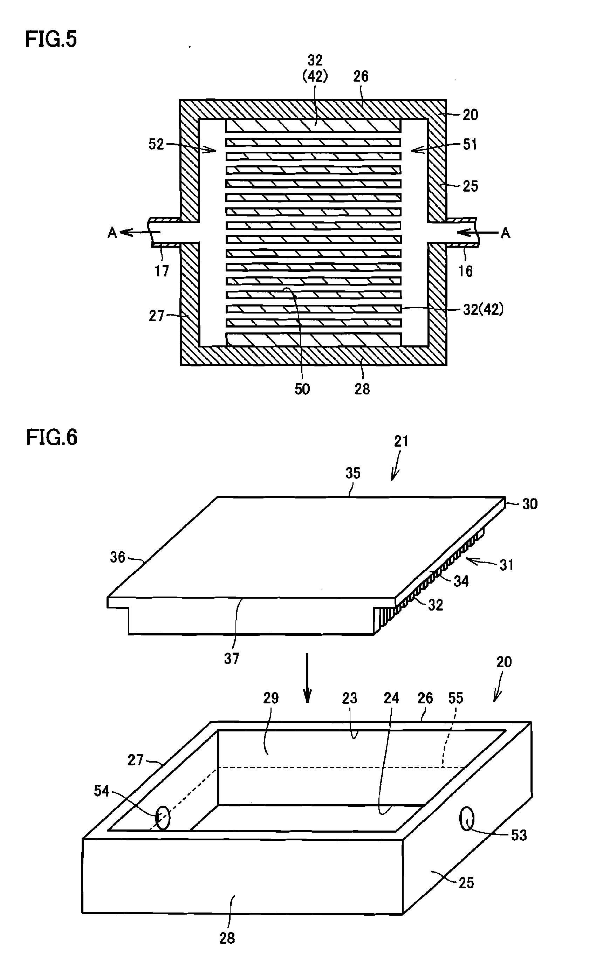

Fig. 5 is a cross section of cooler 14. As shown in Fig. 5, radiating fin 32(42) has an end portion closer to wall portion 25, receding toward wall portion 27, and a liquid reservoir portion 51 extending along wall portion 25 is thus provided.

Radiating fin 32(42) has an end portion closer to wall portion 27, receding toward wall portion 25, and a liquid reservoir portion 52 along wall portion 27 is thus provided.

Liquid reservoir portion 51 provides communication between supply pipe 16 and each coolant path 50. From supply pipe 16 coolant A enters liquid reservoir portion 51 and spreads therein. Coolant A is thus supplied to each coolant path 50.

Coolant A passing through coolant path 50 cools devices 12 and 13, device 19, and reactor L shown in Fig. 4 and the like.

Liquid reservoir portion 52 is connected to each coolant path 50 and discharge pipe 17. Coolant A is discharged from each coolant path 50 to liquid reservoir portion 52 and then flows into discharge pipe 17.

A method for producing cooler 14 configured as described above will be described with reference to Figs. 6-11.

Fig. 6 is a perspective view showing a first step of a process for producing cooler 14. As shown in Fig. 6, radiator 21 is prepared. Radiator 21 is formed by extrusion molding. Specifically, initially, extrusion molding is employed to provide an extrusion-molded product having an elongate substrate and a plurality of fin members formed in one piece with the substrate on a major surface of the substrate. The fin members are then notched at prescribed intervals. The notched extrusion-molded product is cut at the notched portions. Radiators 21 and 22 are thus produced.

Housing 20 is prepared. Housing 20 is formed by extrusion molding. Specifically, extrusion molding is employed to provide a hollow quadrangle member.

The hollow member is then cut to have a prescribed length to form a frame member including wall portions 25, 26, 27, 28. Then, wall portion 25 is provided with a supply port 53 and wall portion 27 is provided with a discharge port 54, and housing 20 is thus produced. Housing 20 and radiator 21 are thus prepared. Radiator 21 is then inserted through opening 23 into housing 20.

In housing 20, for example, a stand 55 is provided to support radiator 21 at radiating fin 32, and thus supports radiator 21 inserted in housing 20.

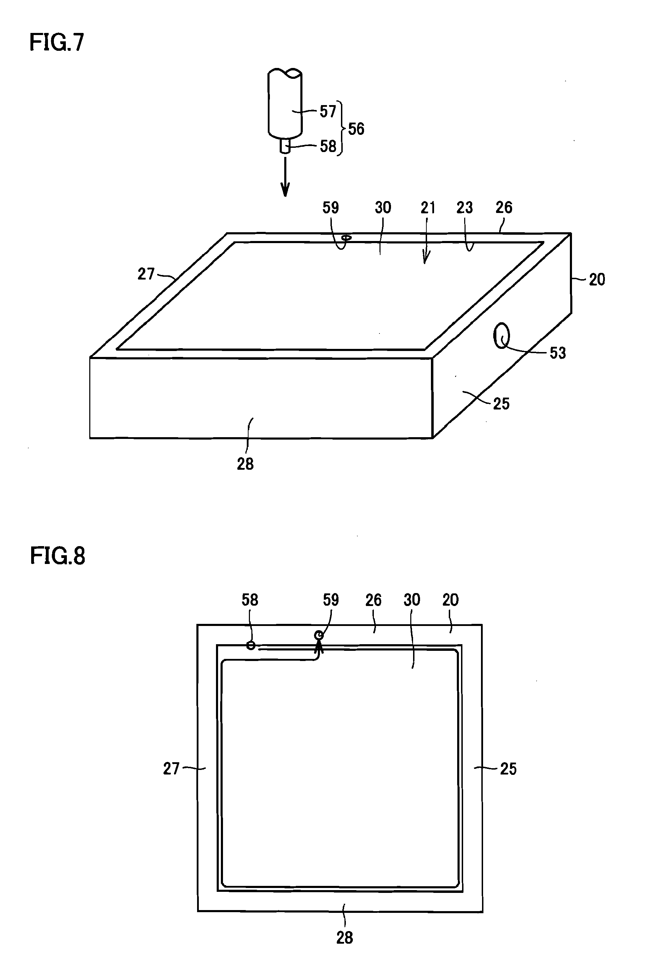

Fig. 7 is a perspective view showing a step after the Fig 6 step. As shown in Fig. 7, when radiator 21 is disposed in housing 20, substrate 30 closes opening 23. In doing so, substrate 30 has a peripheral portion in contact with an edge of opening 23, and internal surface 29.

Then, substrate 30 and housing 20 are joined together. In the present embodiment, a joining tool 56 is used to join housing 20 and substrate 30 together by friction stir welding.

Joining tool 56 includes a rotating portion 57, and a pin 58 provided at a lower end of rotating portion 57. As rotating portion 57 rotates, pin 58 also rotates. To join housing 20 and substrate 30 together, pin 58 is inserted between housing 20 and substrate 30 at their respective surfaces abutting against each other.

Fig. 8 is a plan view showing the step of joining housing 20 and substrate 30 together. In the Fig. 8 example, pin 58 is inserted between substrate 30 and wall portion 26 at their respective surfaces abutting against each other. Then pin 58 is rotated and, in that condition, moved between substrate 30 and wall portion 26 on their respective surfaces abutting against each other. Pin 58 is thus moved along the peripheral portion of substrate 30 once, and thereafter, furthermore moved along the peripheral portion of substrate 30. Pin 58 is then pulled out from a hole 59 formed in an upper surface of wall portion 26. Housing 20 and heat radiation unit 31 can thus be joined together.

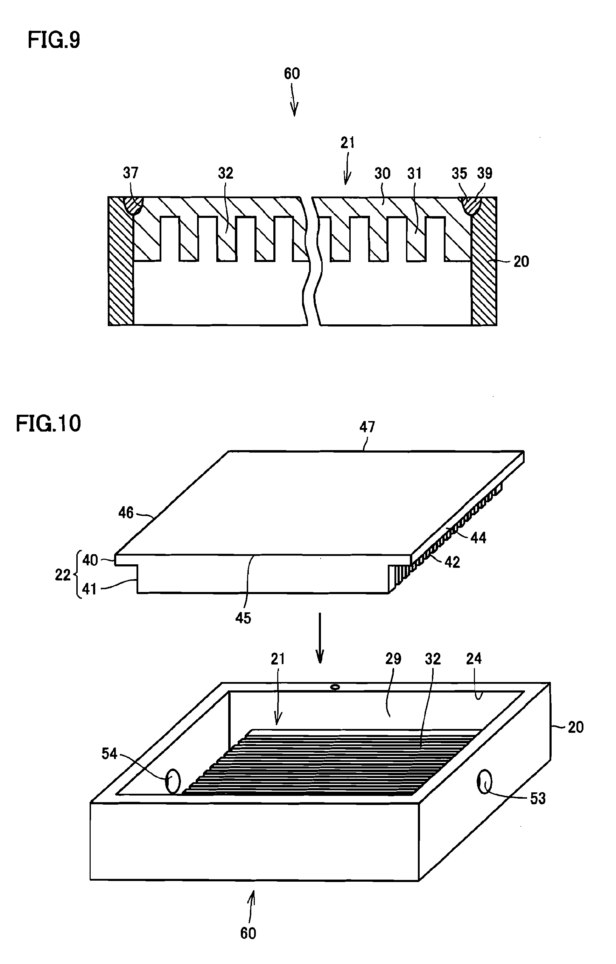

Fig. 9 is a cross section of housing 20 and radiator 21 joined together. As shown in Fig. 9, radiator 21 is joined at substrate 30 to housing 20 via joining portion 39, and an intermediate product 60 is thus produced.

When radiator 21 is joined to housing 20, radiator 21 may not be supported by the stand. For example, before radiator 21 is joined to housing 20, radiator 21 may be disposed in housing 20 and radiators 22 and 21 may have their respective radiating fins 42 and 32 with their respective tips abutting against each other to support radiator 21.

Heat radiation unit 31 is larger in width at side portions 35 and 37 than at the remainder thereof, and radiator 21 can be joined to housing 20 via substrate 30 without substrate 30 having a disadvantageously flexed peripheral portion.

Fig. 10 is a perspective view showing a step after intermediate product 60 is produced. As shown in Fig. 10, radiator 22 is prepared. Note that as well as radiator 21, radiator 22 is also extrusion-molded.

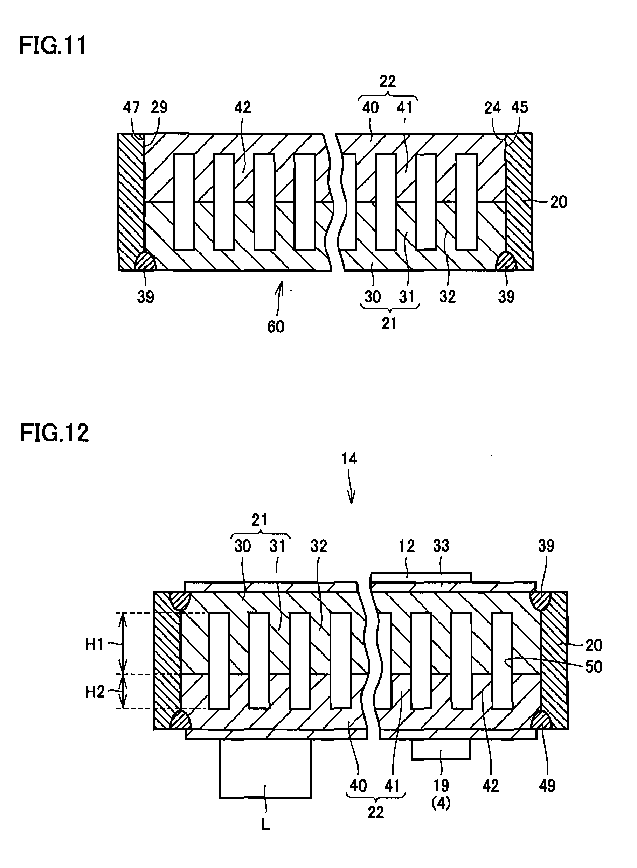

Then, radiator 22 is inserted into housing 20 at opening 24 of intermediate product 60. Fig. 11 is a cross section showing intermediate product 60 with radiator 22 inserted therein. As shown in Fig. 11, when radiator 22 is disposed in housing 20 of intermediate product 60, radiators 22 and 21 have their respective radiating fins 42 and 32 with their respective tips abutting against each other.

Furthermore, radiator 22 has substrate 40 with a peripheral portion in contact with housing 20 at an edge of opening 24, and internal surface 29. This positions radiator 22 and intermediate product 60 relatively.

Thus, with radiator 22 supported by radiator 21, substrate 40 and housing 20 are joined by friction stir welding to produce cooler 14.

Radiating fins 42 located at side portions 45 and 47 are formed to be larger in width than the other radiating fins 42. Substrate 40 can thus be joined to housing 20 without having a disadvantageously flexed peripheral portion.

Cooler 14 according to the present embodiment can have radiators 21 and 22 and housing 20 formed mainly by extrusion molding. More specifically, it does not require a cutting step or the like for forming a step on internal surface 29 of housing 20 to support substrates 30 and 40, and can thus be produced at a reduced cost.

Furthermore, in joining radiator 22, radiator 21 can be utilized as a stand to simplify production facilities.

### Second Embodiment

With reference to Fig. 12, cooler 14 according to a second embodiment will be described. Note that some of the Fig. 12 configuration identical or corresponding to those shown in Figs. 1-11 may be identically denoted and not be described.

Fig. 12 is a cross section of cooler 14 according to the second embodiment. As shown in Fig. 12, radiator 21 has radiating fin 32 with a height H1 and radiator 22 has radiating fin 42 with a height H2, and height H1 is larger than height H2. Accordingly, radiating fin 32 has a larger surface area than radiating fin 42, and radiator 21 cools objects more efficiently than radiator 22.

Generally, device 12 that forms inverters 5 and 6 generates heat in a larger amount than reactor L, device 19 and the like. Cooler 14 according to the present embodiment can cool device 12 satisfactorily.

### Third Embodiment

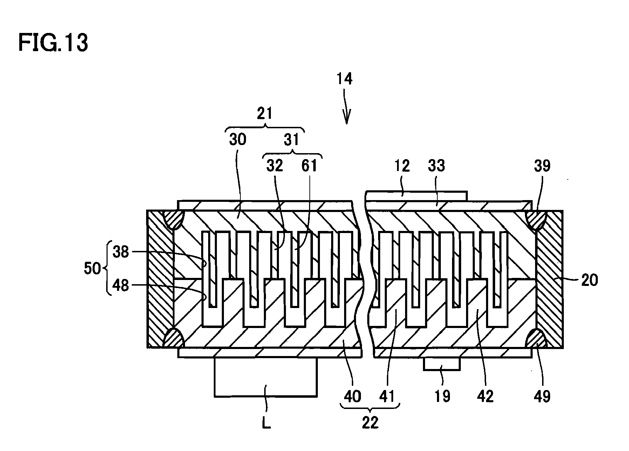

Fig. 13 is a cross section of cooler 14 according to a third embodiment. Note that some of the Fig. 13 configuration identical or corresponding to those shown in Figs. 1-12 may be identically denoted and not be described.

As shown in this Fig. 13, cooler 14 includes housing 20 and radiators 21 and 22. Radiator 21 has heat radiation unit 31 including a plurality of radiating fins 32 and a plurality of contactless fins 61. Each contactless fin 61 is disposed between radiating fins 32. Note that cooler 14 according to the third embodiment also has radiating fins 32 and contactless fins 61 extending in the first direction.

Herein, contactless fin 61 extends from substrate 30 towards radiator 22, and contactless fin 61 is formed to extend between grooves 48.

Cooler 14 according to the third embodiment also has radiating fins 32 and 42 with their respective tips abutting against each other. On the other hand, contactless fin 61 is separated from radiating fin 42, and contactless fin 61 does not contact radiating fin 42.

Radiator 21 includes a plurality of radiating fins 32 and a plurality of contactless fins 61, and radiator 21 cools objects more efficiently than radiator 22.

This allows device 12 of inverters 5 and 6 provided at radiator 21 to be cooled satisfactorily.

### Fourth Embodiment

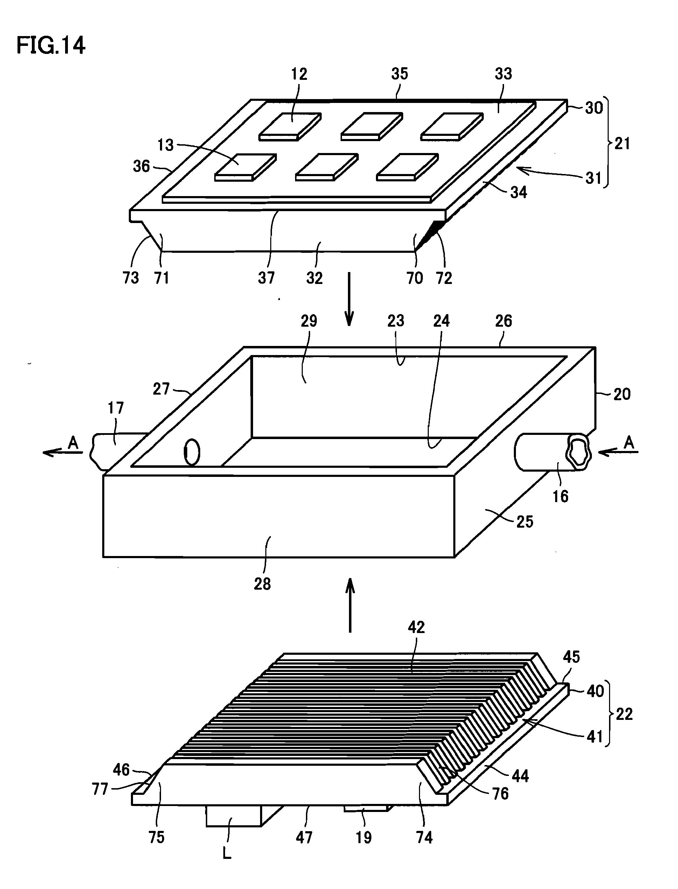

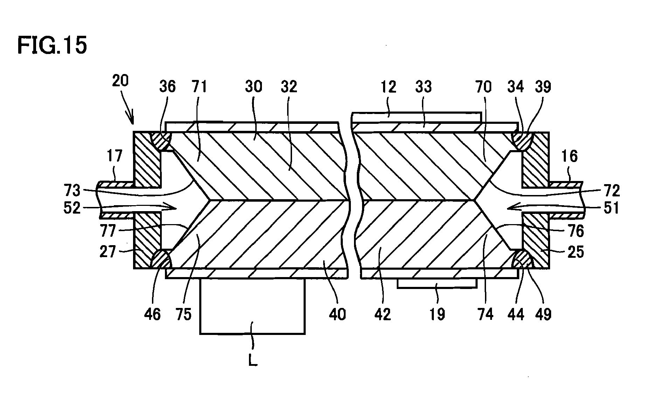

With reference to Figs. 14 and 15, cooler 14 according to a fourth embodiment will be described. Note that some of the Figs. 14 and 15 configurations identical or corresponding to those shown in Figs. 1-13 may be identically denoted and not be described.

Fig. 14 is an exploded perspective view of cooler 14 according to the fourth embodiment. Fig. 15 is a side cross section of cooler 14.

In Fig. 14, radiating fin 32 extends in the first direction, and a plurality of radiating fins 32 are spaced in the second direction. Similarly, radiating fin 42 extends in the first direction, and a plurality of radiating fins 42 are spaced in the second direction.

Radiating fin 32 includes an end portion 70 located closer to side portion 34 of substrate 30, and an end portion 71 located closer to side portion 36 of substrate 30.

End portion 70 is reduced in height toward side portion 34 and has an inclined end side portion 72. End portion 71 is also reduced in height toward side portion 36 and also has an inclined end side portion 73.

Radiating fin 42 includes an end portion 74 located closer to side portion 44 of substrate 40, and an end portion 75 located closer to side portion 46 of substrate 40. End portion 74 is reduced in height toward side portion 44 and end portion 75 is also reduced in height toward side portion 46.

End portion 74 has an inclined end side portion 76 and end portion 75 also has an inclined end side portion 77.

In Fig. 15, end portion 70 has end side portion 72 increased in height as it is farther away from wall portion 25 of housing 20, and end side portion 76 also has end portion 74 increased in height as it is farther away from wall portion 25.

A plurality of radiating fins 32 and a plurality of radiating fins 42 are aligned along wall portion 25. Accordingly, a plurality of end side portions 72, a plurality of end side portions 76, and wall portion 25 define liquid reservoir portion 51.

This allows end side portion 72 to have a foot close to side portion 34, and furthermore, end portion 74 to similarly have a foot close to side portion 44.

End side portion 73 is increased in height as it is farther away from wall portion 27, and end side portion 77 is also increased in height as it is farther away from wall portion 27.

Accordingly, a plurality of end side portions 73, a plurality of end side portions 77, and wall portion 27 define liquid reservoir portion 52.

This allows end side portion 73 to have a foot close to side portion 36, and furthermore, end side portion 77 to similarly have a foot close to side portion 46.

Thus, radiating fin 32 is formed immediately close to side portions 34 and 36 and radiating fin 42 is formed immediately close to side portions 44 and 46, and radiating fin 32 and radiating fin 42 have their respective tip surfaces abutting against each other.

Accordingly, substrate 30 is high in rigidity around side portions 34 and 36 and substrate 40 is high in rigidity around side portions 44 and 46.

Substrate 30 that is high in rigidity around side portions 34 and 36 can be joined to housing 20 without side portions 34 and 36 disadvantageously flexing as they are pressed by a tool.

Similarly, substrate 40 that is high in rigidity around side portions 44 and 46 can be joined to housing 20 without side portions 44 and 46 disadvantageously flexing as they are pressed by the tool.

### Fifth Embodiment

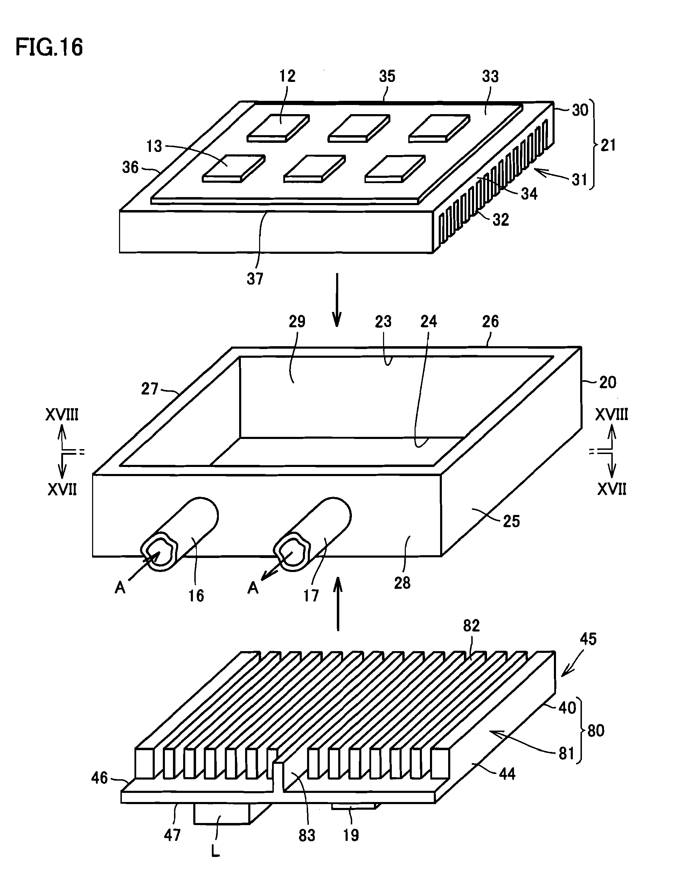

With reference to Figs. 16 to 18, cooler 14 according to a fifth embodiment will be described. Note that some of the Figs. 16 to 18 configurations identical or corresponding to those shown in Figs. 1-15 may be identically denoted and not be described.

Fig. 16 is an exploded perspective view of cooler 14 according to the fifth embodiment. As shown in Fig. 16, cooler 14 according to the fifth embodiment includes housing 20, radiator 21, and a radiator 80.

Housing 20 is formed in a frame and has wall portions 25, 26, 27, 28. Wall portions 25 and 27 are aligned in the first direction, and wall portions 26 and 28 are aligned in the second direction.

Wall portion 28 has supply pipe 16 and discharge pipe 17 connected thereto, and supply pipe 16 and discharge pipe 17 are mutually spaced in the first direction.

Radiator 21 has radiating fin 32 extending in the first direction, and a plurality of radiating fins 32 are spaced in the second direction.

Radiator 80 includes substrate 40 and a heat radiation unit 81 formed in one piece with substrate 40, and heat radiation unit 81 includes a diaphragm 83 and a plurality of radiating fins 82.

Substrate 40 is formed in a plate and has two main surfaces aligned depthwise. One main surface is provided with heat radiation unit 81, and the other main surface is provided with reactor L, device 19 and the like.

Substrate 40 includes side portions 44, 45, 46, 47, and side portions 44 and 46 are aligned in the first direction and side portions 45 and 47 are aligned in the second direction.

Diaphragm 83 is formed on one main surface at a center as seen in a direction in which side portions 44 and 46 are aligned. Diaphragm 83 is formed across one main surface from side portion 45 to side portion 47.

Radiating fins 82 are provided on one main surface between diaphragm 83 and side portion 44 and between diaphragm 83 and side portion 46.

Radiating fin 82 is elongate in the second direction. Radiating fin 82 has an end portion closer to side portion 47, receding from side portion 47 toward side portion 45, and radiating fin 82 has an end portion closer to side portion 45, reaching side portion 45.

When radiating fins 82 and 32 are seen in a direction in which radiators 21 and 22 are aligned, radiating fins 82 and 32 cross each other.

Specifically, radiating fin 82 has a tip in contact with those of a plurality of radiating fins 32. Note that diaphragm 83 also has a tip in contact with those of a plurality of radiating fins 32. Similarly, radiating fin 32 also has a tip in contact with those of a plurality of radiating fins 82 and that of diaphragm 83.

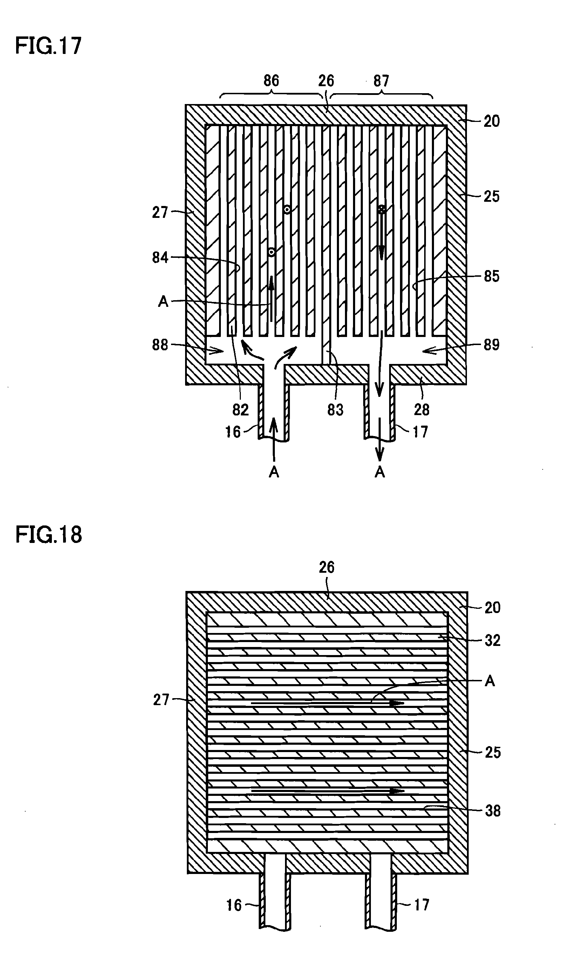

Fig. 17 is a cross section taken along a line XVII-XVII shown in Fig. 16 and Fig. 18 is a cross section taken along a line XVIII-XVIII.

In Fig. 17, diaphragm 83 is disposed to divide a space in housing 20 into a first coolant chamber 86 and a second coolant chamber 87.

More specifically, diaphragm 83 is formed to divide the space in housing 20 into first and second coolant chambers 86 and 87 at a portion closer to opening 24 than a center as seen in a direction in which openings 23 and 24 are aligned.

Supply pipe 16 communicates with first coolant chamber 86, and discharge pipe 17 communicates with second coolant chamber 87.

In first coolant chamber 86 a plurality of radiating fins 82 are aligned, and between radiating fins 82 grooves 84 are each formed.

Radiating fin 82 has an end portion closer to wall portion 28, spaced from wall portion 28 toward wall portion 26. Accordingly, the end portions of a plurality of radiating fins 82, wall portion 28, and diaphragm 83 define a liquid reservoir portion 88 reserving coolant A. Liquid reservoir portion 88 is connected to each groove 84 and supply pipe 16.

Second coolant chamber 87 also has a plurality of radiating fins 82 disposed therein, and between radiating fins 82 grooves 85 are each formed.

Second coolant chamber 87 also has radiating fins 82 disposed closer to wall portion 26 than wall portion 28. Accordingly, second coolant chamber 87 also has a liquid reservoir portion 89 defined by the end portions of a plurality of radiating fins 82, wall portion 28, and diaphragm 83. Liquid reservoir portion 89 communicates with each groove 85 and also communicates with discharge pipe 17.

In Fig. 18, radiating fins 82 are disposed in the space in housing 20 at a position closer to opening 23 than the center as seen in the direction in which openings 23 and 24 are aligned.

Between radiating fins 32 grooves 38 are each formed. Grooves 38 extend to allow grooves 84 and 85 shown in Fig. 17 to communicate with each other.

Cooler 14 thus configured operates as follows: Initially, coolant A delivered through supply pipe 16 enters liquid reservoir portion 88, as shown in Fig. 17. Coolant A then passes through liquid reservoir portion 88 into grooves 84. Then, as shown in Fig. 18, coolant A enters grooves 38 and passes therethrough. Coolant A then enters grooves 85 shown in Fig. 17.

Then, coolant A passes through grooves 85 and enters liquid reservoir portion 89, and then passes through discharge pipe 17 and is discharged outside cooler 14.

The present cooler thus allows a radiator to be modified in direction to modify where supply pipe 16 and discharge pipe 17 are connected. This facilitates changing a design and thus applying it to a variety of vehicles.

Note that cooler 14 according to the fifth embodiment also allows a substrate to have a periphery joined to housing 20 with the radiating fins in contact with each other for a simplified production process or the like.

Furthermore, the present embodiment also provides housing 20 having internal surface 29 without a step for supporting a substrate and thus provides cooler 14 compactly.

It should be understood that the embodiments disclosed herein have been described for the purpose of illustration only and in a non-restrictive manner in any respect. The scope of the present invention is defined by the terms of the claims, and is intended to include any modifications within the scope and meaning equivalent to the terms of the claims. Furthermore, the numerical values indicated above and the like are illustrative and are not limited as such.

### INDUSTRIAL APPLICABILITY

The present invention is applicable to coolers and methods for producing the same.

### REFERENCE SIGNS LIST

1: engine; 2: power split device; 3: front wheel; 4: converter; 5, 6: inverter; 11: cooling circuit; 12, 13: device; 14: cooler; 15: heat exchanger; 16: supply pipe; 17: discharge pipe; 18: pump; 20: housing; 21, 22, 80: radiator; 23, 24: opening; 25, 26, 27, 28: wall portion; 29: internal surface; 30, 40: substrate; 31, 41, 81: heat radiation unit; 32, 42, 82: radiating fin; 33: heat sink; 34, 34, 35, 36, 37, 44, 46, 47: side portion; 38, 48, 84, 85: groove; 39, 49: joining portion; 50: coolant path; 51, 52, 88, 89: liquid reservoir portion; 53: supply port; 54: discharge port; 55: stand; 56: joining tool; 57: rotating portion; 58: pin; 59: hole; 60: intermediate product; 61: contactless fin; 70, 71, 74, 75: end portion; 72, 73, 76, 77: end side portion; 83: diaphragm; 86: first coolant chamber; 87: second coolant chamber; W1, W2: width.

## Claims

1. A cooler comprising:
a housing (20) in a form of a frame including a first opening (23) and a second opening (24) opposite to each other;
a first radiator (21) including a first substrate (30) joined to said housing (20) to close said first opening (23), and a first heat radiation unit (31) provided on said first substrate (30); and
a second radiator (22, 80) including a second substrate (40) joined to said housing (20) to close said second opening (24), and a second heat radiation unit (41, 81) provided on said second substrate (40),
said first heat radiation unit (31) having a plurality of first fins (32),
said second heat radiation unit (41, 81) having a plurality of second fins (42, 82),
said first fins (32) each abutting against a tip of at least one of said second fins (42, 82).

2. The cooler according to claim 1, wherein:
said housing (20) has an internal surface having a cross section, as seen in a direction perpendicular to that in which said first opening (23) and said second opening (24) are aligned, unvarying in geometry between said first opening (23) and said second opening (24);
said first substrate (30) has a peripheral portion joined to said housing (20) at said internal surface; and
said second substrate (40) has a peripheral portion joined to said housing (20) at said internal surface.

3. The cooler according to claim 1, wherein said housing (20) is extrusion-molded.

4. The cooler according to claim 1, wherein said first radiator (21) and said second radiator (22, 80) are extrusion-molded.

5. The cooler according to claim 1, wherein:
said first fins (32) extend in a first direction and are spaced in a second direction traversing said first direction;
said second fins (42) extend in said first direction and are spaced in said second direction; and
said first heat radiation unit (31) has a contactless fin (61) positioned between said first fins (32) and out of contact with said second fins.

6. The cooler according to claim 1, wherein:
said first fins (32) extend in a first direction and are spaced in a second direction traversing said first direction;
said second fins (42) extend in said first direction and are spaced in said second direction;
said first substrate (30) has a peripheral portion including a first side portion and a second side portion aligned in said first direction;
said first fin (32) includes a first end portion located closer to said first side portion, and a second end portion located closer to said second side portion;
said housing (20) includes a first wall portion joined to said first side portion and having a supply port receiving a coolant, and a second wall portion joined to said second side portion and having a discharge port to discharge said coolant;
said first end portion is reduced in height as said first end portion approaches said first side portion; and
said second end portion is reduced in height as said second end portion approaches said second side portion.

7. The cooler according to claim 6, wherein:
said second substrate (40) has a peripheral portion including a third side portion and a fourth side portion aligned in said first direction;
said second fin (42) includes a third end portion located closer to said third side portion, and a fourth end portion located closer to said fourth side portion;
said third end portion is reduced in height as said third end portion approaches said third side portion; and
said fourth end portion is reduced in height as said fourth end portion approaches said fourth side portion.

8. The cooler according to claim 1, wherein:
said first fins (32) extend in a first direction; and
said second fins (82) extend in said second direction traversing said first direction and are spaced in said first direction.

9. The cooler according to claim 8, wherein:
said housing (20) includes a third wall portion and a fourth wall portion aligned in said second direction;
said third wall portion has a supply port receiving a coolant, and a discharge port to discharge said coolant;
said second heat radiation unit (81) includes a diaphragm to divide an interior of said housing (20) into a first coolant chamber and a second coolant chamber; and
said supply port communicates with said first coolant chamber and said discharge port communicates with said second coolant chamber.

10. The cooler according to claim 1, wherein said first fins (32) are larger in height than said second fins.

11. The cooler according to claim 1, wherein said first radiator and said second radiator are geometrically identical.

12. A method for producing a cooler, comprising the steps of:
preparing a housing (20) in a form of a frame including a first opening (23) and a second opening (24) opposite to each other;
preparing a first radiator (21) including a first substrate (30) and a plurality of first fins (32) formed on said first substrate (30);
joining a peripheral portion of said first substrate (30) to an internal surface of said first opening (23);
preparing a second radiator (22, 80) including a second substrate (40) and a plurality of second fins formed on said second substrate (40); and
joining a peripheral portion of said second substrate (40) to an internal surface of said housing (20), with said second fin and said first fin (32) abutting against each other.

13. The method for producing a cooler according to claim 12, further comprising the step of forming said housing (20) by extrusion molding.

14. The method for producing a cooler according to claim 12, further comprising the steps of:
forming said first radiator (21) by extrusion molding; and
forming said second radiator (22, 80) by extrusion molding.

15. The method for producing a cooler according to claim 12, wherein:
said first substrate and said housing are friction-stir-welded together; and
said second substrate and said housing are friction-stir-welded together.
